# EUROPÄISCHE PATENTSCHRIFT

(11) **EP 2 002 433 B1**
(45) Veröffentlichungstag und Bekanntmachung des Hinweises auf die Patenterteilung: **26.05.2010**
(21) Anmeldenummer: 07723140.5
(22) Anmeldetag: 09.03.2007
(51) Int. Cl.: G11B 7/0065, G03H 1/16

(54) **VERFAHREN UND SYSTEM ZUM OPTISCHEN AUSLESEN VON INFORMATIONEN**
METHOD AND SYSTEM FOR OPTICALLY READING INFORMATION
PROCEDE ET SYSTEME POUR LA LECTURE OPTIQUE D'INFORMATIONS

(30) Priorität: 22.03.2006 DE 102006012991
(43) Veröffentlichungstag der Anmeldung: 17.12.2008
(73) Patentinhaber: Bayer Innovation GmbH, 40225 Düsseldorf (DE)
(72) Erfinder: VÖLKENING, Stephan, 50670 Köln (DE); HUPE, Torsten, 82041 Oberhaching (DE)
(74) Vertreter: Hildebrand, Steven
(86) Internationale Anmeldenummer: PCT/EP2007/002060
(87) Internationale Veröffentlichungsnummer: WO 2007/107251

(56) Entgegenhaltungen:
- EP-A- 1 252 623
- EP-A1- 1 080 466
- US-A- 4 094 011
- US-A- 5 336 871
- US-A- 5 644 412
- US-A1- 2005 100 222
- US-B1- 6 328 209
- LIN L H: "A METHOD OF HOLOGRAM INFORMATION REDUCTION BY SPATIAL FREQUENCY SAMPLING" APPLIED OPTICS, OSA, OPTICAL SOCIETY OF AMERICA, WASHINGTON, DC, US, Bd. 7, Nr. 3, März 1968 (1968-03), Seiten 545-548, XP008036206 ISSN: 0003-6935

## Beschreibung

Die vorliegende Erfindung betrifft ein Verfahren und eine Vorrichtung, mit der ein Informationsträger ausgelesen werden kann, auf dem Informationen in Form von Beugungsstrukturen gespeichert sind. Der Informationsträger kann durch manuellen Durchzug durch eine Auslesevorrichtung ausgelesen werden.

Plastikkarten als Informationsträger sind heutzutage allgegenwärtig. In Folge der zunehmenden maschinellen Datenverarbeitung verfügt eine Person typischerweise über eine Reihe von Plastikkarten, mit denen sie sich authentifizieren kann. Als Beispiele seien Firmenausweise, Krankenkassenausweise, Kredit-, EC- und Payback-Karten genannt.

Besonders verbreitet ist das Format ID-1, das in dem Standard ISO/IEC 7810 charakterisiert ist ("Kreditkartenformat"). Es hat eine handliche Größe und lässt sich in Portemonnaies unterbringen. Es gibt viele Kartenlesegeräte, die auf dieses Format ausgerichtet sind.

Auf Plastikkarten können auf verschiedene Weisen maschinenlesbare Informationen abgelegt werden. Z.B. optisch in Form von optisch lesbaren Buchstaben (OCR = *Optical Character Recognition*), Bar- oder Matrixcodes, magnetisch in einem Magnetstreifen oder elektronisch in einem Chip. Die genannten Speichermethoden erlauben jedoch lediglich die Speicherung von wenigen Bytes (OCR) bis Kilobytes (Chip). Die größte Speicherkapazität bei Plastikkarten erreichen heute optische Speicherkarten.

In W08808120 (A1) und EP0231351 (A1) sind optische Speicherkarten beschrieben, bei denen Daten fotografisch in einen Silberhalogenidfilm, der auf die Plastikkarten aufgebracht ist, belichtet werden. Die Daten können mit einem Laser eingeschrieben und ausgelesen werden. In W08808120 (A1) ist eine Vorrichtung beschrieben, mit welcher der Film beschrieben und ausgelesen werden kann. Die Daten liegen digital in Form von Datenpunkten vor. Die Datenpunkte weisen eine unterschiedliche Reflektivität gegenüber der Umgebung auf und können so mit Hilfe eines Laserstrahls und eines Fotodetektors gelesen werden.

Nachteilig an der beschriebenen Karte und dem Kartenleser ist, dass die Karte genau bezüglich Auslesestrahl und Detektor positioniert werden muss, um die Daten lesen zu können. Um die einzelnen Datenpunkte nacheinander auszulesen, muss die Karte ferner in Bezug zu Lesestrahl und Detektor so bewegt werden, dass der Lesestrahl die Datenpunkte genau trifft. Dies erfordert ein komplexes Kartenlesegerät mit einer hohen Positioniergenauigkeit. Darüber hinaus ist die Datendichte auf der Karte beschränkt auf das Maß der Positioniergenauigkeit beim Auslesen. Liegen die Datenpunkte dichter als die Positioniergenauigkeit des Lesestrahls ist, so können die einzelnen Datenpunkte nicht mehr detektiert werden.

Bei der Benutzung von Barcode- oder Magnetstreifenkarten ist es möglich, die Karte zum Auslesen durch eine Kartenführung zu ziehen. Die Daten werden beim manuellen Durchziehen ausgelesen. Eine maschinelle Positionierung von Lesekopf in Bezug zur Karte ist nicht notwendig.

Ein solches Kartendurchzugsystem für Magnetstreifenkarten ist z.B. beschrieben in US5128524 (A1). EP 1 252 623 A beschreibt eine Vorrichtung zum Lesen von auf einer Karte gespeicherten Fourierhologrammen, welche zum Lesen der verschiedenen Hologramme eine Positionierung der Karte relativ zur Ausleseoptik vornimmt und dann in dieser Position die Hologramme liest. US 6 328 209 B1 beschreibt ein Leseverfahren für eine Karte mit einem als Fourierhologramm gespeicherten Barcode, einem Magnetstreifen und einem weiteren Hologramm als Identifikationsmerkmalen. US 5 336 871 A beschreibt ein manuelles Durchzugslesegerät für eine Karte mit holographisch gespeichertem Barcode.

Die Realisierung eines manuellen Kartendurchzugsystems zum Auslesen von Daten, die auf Plastikkarten gespeichert sind, ist bei Magnetstreifen und Barcodes möglich, weil die Datendichte (Menge der Bytes pro Flächeneinheit) so gering ist, dass die Positionierung des Speichermediums in Bezug zum Lesekopf tolerant gegenüber den Änderungen ist, die bei der manuellen Kartenführung auftreten.

Bei den oben beschriebenen optischen Speicherkarten sind die Datenstrukturen kleiner. Eine manuelle Positionierung der Karte in Bezug zum Lesekopf ist daher in der Regel nicht mehr möglich.

Es wäre aber wünschenswert, optische Speicherkarten mit einer höheren Speicherkapazität als bei Magnetstreifen- oder Barcode-Karten üblich, mit Hilfe eines manuell bedienbaren Kartendurchzugsystems auslesen zu können.

Vorteile der manuellen Kartenführung sind zum einen der höhere Komfort für den Benutzer, da er die Karte nicht aus der Hand geben muss, eine hiermit verbundene erhöhte Geschwindigkeit des gesamten Leseprozesses und zum anderen geringere Herstellkosten des Geräts, da auf eine teure maschinelle Positionierung verzichtet werden kann, sowie auch eine höhere Robustheit des Geräts.

Es bestand daher die Aufgabe, eine optische Speicherkarte bereitzustellen, die mit Hilfe eines manuell bedienbaren Kartendurchzugsystems auslesbar ist.

Überraschend wurde gefunden, dass diese Aufgabe durch die nachfolgend beschriebenen optischen Speicherkarten gelöst wird.

Insbesondere können die optischen Speicherkarten beim manuellen Durchzug durch eine Kartenführung ausgelesen werden, obwohl die Strukturen, welche die Daten im Speichermedium repräsentieren, kleiner sind als die Positioniergenauigkeit beim manuellen Durchzug.

Weiterhin weisen die optischen Speicherkarten eine höhere Speicherkapazität als die aus dem Stand der Technik bekannten Speicherkarten auf.

Dies wird erreicht durch Informationsträger, insbesondere optische Speicherkarten, auf denen Daten in Form von Fourierhologrammen gespeichert sind.

In einer Ausführungsform liegen die auszulesenden Informationen (Daten) in Form von Fourierhologrammen auf einem flachen Informationsträger, beispielsweise einer Plastikkarte vor.

Als Speichermedium für das Hologramm kommen alle üblichen und dem Fachmann bekannten Materialien in Betracht, bei denen sich eine flache Oberfläche erzeugen lässt. Beispiele hierfür sind Polymere, Metalle, Papiere, Textilien, Lacke, Steingut u.a., in denen die holographischen Strukturen mittels Prägung, Ätzung, Fotolithographie, Granolithographie, Abrasion oder Schneidung eingebracht sind. Es sind auch Verbundmaterialien denkbar, die durch Kombination der oben genannten Materialien gebildet werden. Ein Beispiel hierfür sind Polymerfolien, auf denen ein Metallfilm aufgebracht ist. Bei photosensitiven Materialien oder Verbundmaterialien mit photosensitiven Komponenten können die holographischen Strukturen auch mit Licht eingebracht werden (Silberhalogenidfilm, Film aus photoadressierbarem Polymer, u.a.).

Als flacher Informationsträger wird ein Informationsträger verstanden, der einen Krümmungsradius aufweist, der wesentlich größer ist als der Informationsträger selbst. Ein solcher flacher Informationsträger ist zum Beispiel eine Kreditkarte, die im Portemonnaie so verbogen wurde, so dass sie einen Krümmungsradius von 3 m aufweist, während die Karte selbst nur etwa 8 cm lang und etwa 5 cm breit ist.

Das Speichermedium für das Hologramm kann dabei sowohl Teil des Informationsträgers selbst sein als auch lediglich mit dem Informationsträger fest verbunden sein.

Die Hologramme können in Reflexion oder Transmission ausgelesen werden. Sie werden bevorzugt in Reflexion ausgelesen. Dazu ist eine lichtreflektierende Oberfläche erforderlich, auf die das Hologramm aufgebracht oder in die das Hologramm eingebracht ist.

Der Informationsträger sollte bevorzugt glatt sein, das heißt die Rauhigkeit sollte kleiner sein als die holographischen Strukturen. Die Rauhigkeit kann z.B. mittels Taststiftverfahren (Messgerät: KLA Tencor Alpha Step 500; Messmethode: MM-40001) bestimmt werden. Die Oberflächenrauhigkeit liegt bevorzugt unterhalb von Rₐ = 10 Mikrometern.

Die holographisch zu speichernden Daten liegen bevorzugt als zweidimensionale Verteilung von Helligkeitswerten vor. Als Beispiel sei der Data Matrix Code genannt, der in ISO/IEC 16022 spezifiziert ist.

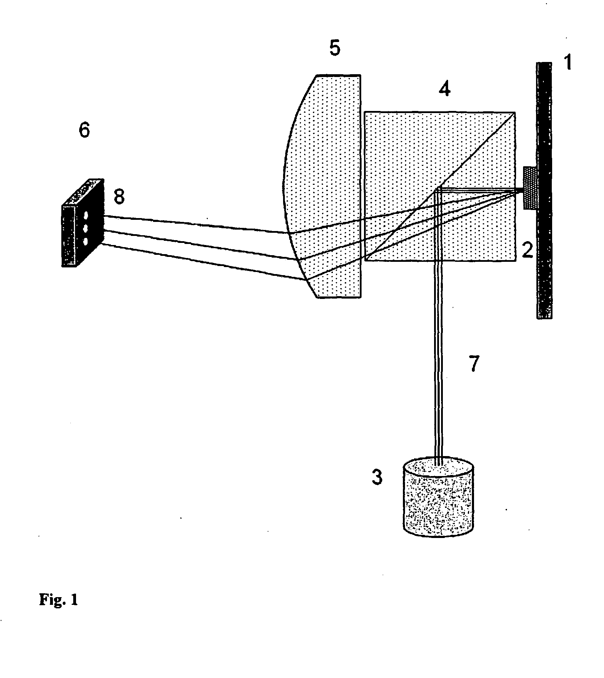

Bei der Speicherung solcher Daten als Fourierhologramme wird die räumliche Helligkeitsverteilung des Objekts im Fourierhologramm in Form von Winkeln kodiert. Dies ist schematisch in Figur 1 dargestellt: Beim Bestrahlen des Fourierhologramms (2) mit einem kollimierten Laserstrahl (7) werden die Lichtstrahlen am Hologramm unter verschiedenen Winkel gebeugt.

Fourierhologramme sind bekannt und ihre Eigenschaften z.B. beschrieben in P. Hariharan, Basics of Holography, Cambridge University Press, 2002, Seiten 8 bis 10.

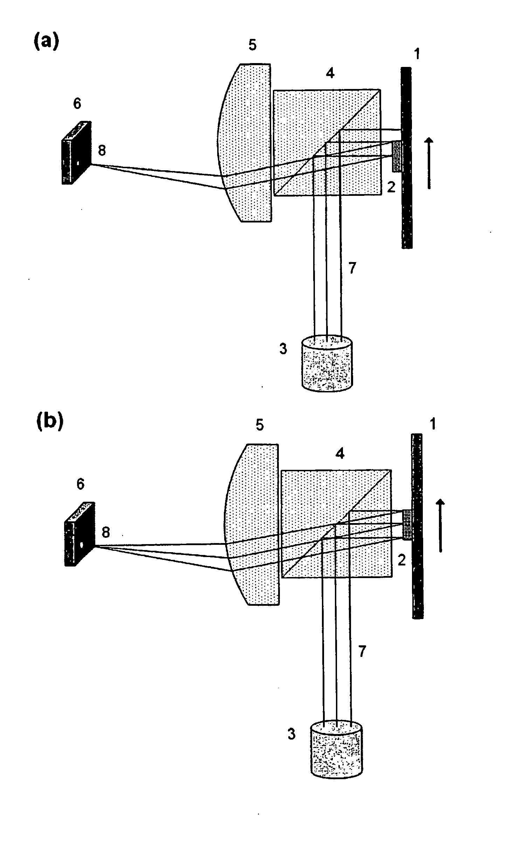

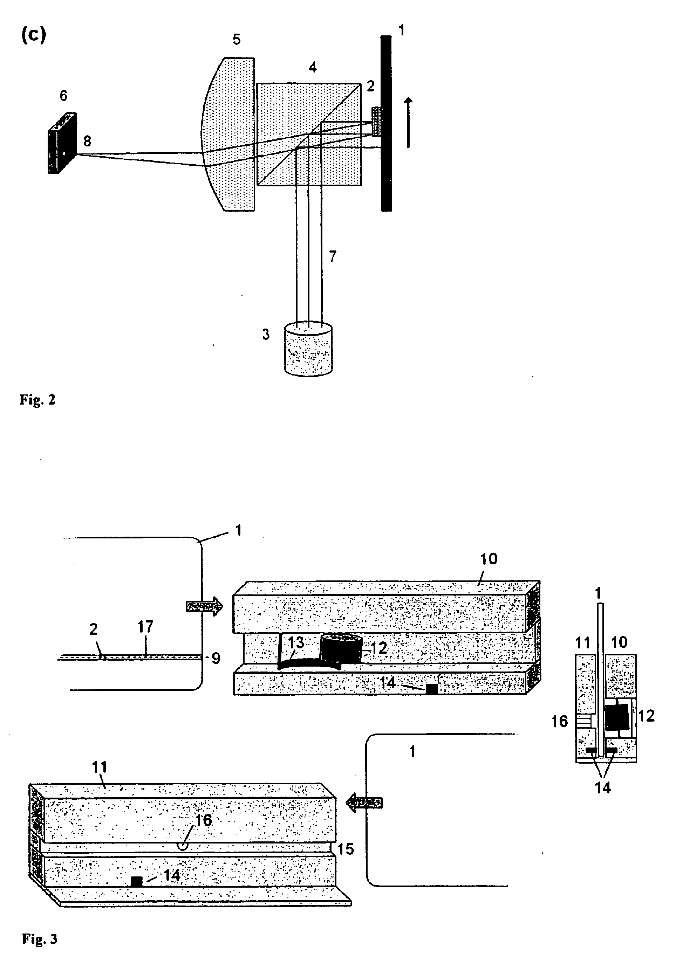

Mit Hilfe einer Fourieroptik können die Winkel wieder in Ortsinformationen zurückgeführt werden (Figur 1 und Figur 2): Die unter demselben Winkel gebeugten Strahlen werden durch die Fourierlinse (5) in einen Punkt fokussiert. Die unter verschiedenen Winkeln gebeugten Strahlen werden durch die Fourierlinse in verschiedene Punkte fokussiert.

Die Punkte können auf einem Detektor, z.B. einer Kamera, abgebildet werden und sind somit elektronisch weiterverarbeitbar.

Eine wichtige Eigenschaft der Fourierhologramme in Kombination mit einer Fourieroptik besteht darin, dass sich die auf dem Detektor abgebildeten Punkte nicht verschieben, wenn das Hologramm senkrecht zum einfallenden Laserstrahl verschoben wird. Es ändert sich lediglich die Intensität der Abbildung auf dem Detektor. Dies ist in Figur 2 verdeutlicht: Wird das Fourierhologramm (2) durch den Auslesestrahl (7) gefahren, erscheint auf dem Detektor ein Abbild, sobald der Auslesestrahl das Hologramm partiell trifft. Die Intensität (Helligkeit) der Abbildung steigt, bis der Auslesestrahl das gesamte Hologramm bestrahlt und nimmt dann wieder auf Null ab, bis der Auslesestrahl das Hologramm nicht mehr beleuchtet.

Überraschend wurde festgestellt, dass dieser Effekt dazu verwendet werden kann, Informationen, die in Form von Fourierhologrammen auf einem flachen Informationsträger gespeichert sind, auszulesen, während der Informationsträger in Bezug zu einem einfallenden Laserstrahl verschoben, also beispielsweise manuell durch eine Führung bewegt wird.

Wird das Hologramm nur teilweise vom Auslesespot erfasst, so ist die Abbildung weniger hell und unschärfer, als wenn das gesamte Hologramm vom Auslesespot erfasst wird. Daraus könnte leicht gefolgert werden, dass es besonders günstig ist, den Auslesespot größer als das Hologramm zu gestalten, damit beim Ausleseprozess immer möglichst viele Bereiche des Hologramms vom Auslesespot erfasst sind. Dies ist jedoch nicht so. Ist der Auslesespot größer als das Hologramm, so werden immer auch Teile des Informationsträgers beleuchtet, die kein Hologramm aufweisen. Dadurch werden generell weniger Lichtstrahlen am Hologramm gebeugt, so dass die Helligkeit sinkt. Daneben führen Streueffekte durch Bestrahlung des Informationsträgers außerhalb des Hologramms zu einem erhöhten Hintergrundrauschen auf dem Detektor.

Überraschend wurde gefunden, dass die Abbildungseigenschaften beim Bestrahlen des Hologramms besonders gut sind, wenn der Auslesespot kleiner als das Hologramm ist. Besonders bevorzugt ist der Auslesespot 0,9- bis 0,1-mal so groß wie das Hologramm.

Besonders gute Abbildungseigenschaften werden erzielt, wenn mehrere Hologramme mit demselben Inhalt zu einem größeren Hologramm direkt aneinandergesetzt werden. Besonders bevorzugt werden 2 bis 9 Hologramme desselben Inhalts direkt aneinandergesetzt und bilden damit ein vergrößertes Hologramm.

Bevorzugt wird die Geometrie der Fourierhologramme an das Profil des Auslesespots angepasst. Konventionelle Laser als Quelle des Auslesestrahls erzeugen einen kreis- oder elliptischförmigen Auslesespot, bei dem die Intensität von innen nach außen abnimmt.

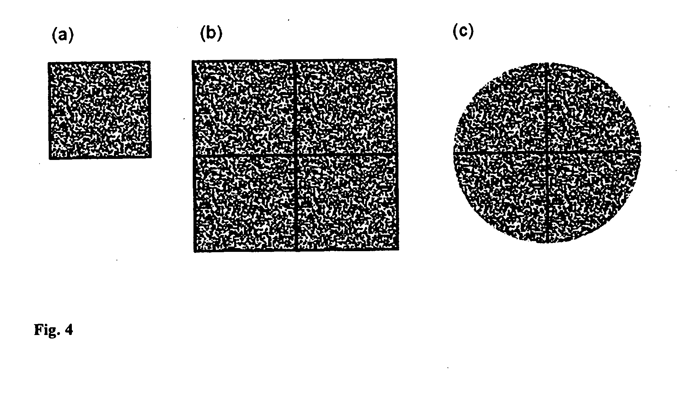

Besonders gute Abbildungen erhält man, wenn man vier Hologramme desselben Inhalts zu einem größeren Hologramm zusammensetzt, von dem nur ein mittlerer kreis- oder elliptischförmiger Bereich, der etwas größer als der Auslesespot ist, auf den Informationsträger aufgebracht wird, wie in Fig. 4 dargestellt: Fig. 4 (a) zeigt ein Fourierhologramm. Dieses wird in Fig. 4 (b) vervierfacht, wobei die vier identischen Hologramme in Form eines Rechtecks angeordnet werden. In Fig. 4 (c) ist das vergrößerte Hologramm so geschnitten, dass das Hologramm die Form des Auslesespots besitzt. Zur besseren Verdeutlichung sind in Fig. 4 die einzelnen Hologramme mit einem schwarzen Rahmen versehen, der aber in Wirklichkeit nicht auftritt.

Die Größe der Hologramme beträgt bevorzugt 0,1 bis 5 mm im Durchmesser.

Eine Vorrichtung zum Auslesen der optischen Speicherkarten
umfasst eine Lichtquelle für einen Auslesestrahl, eine Fourieroptik, einen Fotodetektor und eine Führungsvorrichtung, welche den Informationsträger während der Bewegung während des Auslesevorgangs, insbesondere des manuellen Durchzugs durch die Vorrichtung in Bezug zum Auslesestrahl und zum Fotodetektor ausrichtet. Die Führung schränkt die Bewegung des Informationsträgers in zwei Raumrichtungen ein, während der Informationsträger in die dritte Raumrichtung bewegt wird. Der Informationsträger wird beispielsweise manuell durch die Führung bewegt und dabei mit einem Lichtstrahl beleuchtet. Der Lichtstrahl wird am Fourierhologramm des Informationsträgers gebeugt und die gebeugten Strahlen werden mit Hilfe einer Fourieroptik auf einen Detektor abgebildet, wo das optische Signal in ein elektronisches Signal transformiert wird.

Mit der Vorrichtung können die optischen Speicherkarten in Transmission und/oder Reflexion ausgelesen werden.

Ein Beispiel für eine Ausführung einer solchen Vorrichtung, mit der Speicherkarten in Reflexion ausgelesen werden, ist in Figur 3 dargestellt. Sie besteht aus zwei Führungsschienen (10 und 11) zwischen denen der Informationsträger (1) manuell bewegt wird. Eine der Führungsschienen (hier 10) verfügt über eine Rolle (12), die mit einer Andrückfeder (13) gelagert ist und den Informationsträger (1) beim manuellen Durchzug gegen die andere Schiene (hier 11) drückt. Die Rolle ist etwas gekippt, sodass ein Informationsträger beim Durchzug automatisch nach unten gedrückt wird. Damit wird der Informationsträger beim manuellen Durchzug sowohl gegen eine Schiene (hier 11) als auch gegen den Boden der Führung gedrückt. Damit sind zwei der drei möglichen Raumrichtungen eingeschränkt. In die dritte Raumrichtung, parallel zu den Führungsschienen 10 und 11, wird der Informationsträger bewegt.

Dabei überstreicht er den Auslesestrahl (7), der durch eine Bohrung (16) in einer der Führungsschienen (hier 11) fällt. Die Bohrung (16) ist in der Höhe des Hologramms (2) auf dem Informationsträger (1) angeordnet. Bevorzugt ist in derselben Höhe, in der Schiene, die dem Hologramm zugewandt ist und in der sich die Bohrung befindet, eine Nut (15) gefräst, die verhindert, dass ein auf dem Informationsträger befindliches Hologramm bei mehrmaligem Durchzug durch die Führung allmählich zerkratzt wird.

Bevorzugt ist in der Führung ein Detektor (14) eingefügt, der erkennt, ob ein Informationsträger durch die Führung bewegt wird. Z.B. kann eine Gabellichtschranke verwendet werden, deren Lichtstrahl durch den Informationsträger unterbrochen wird. Die Unterbrechung des Lichtstrahls der Lichtschranke kann als Trigger für den Auslesestrahl (3) und den Detektor (Kamera) (6) verwendet werden. Sobald die Lichtschranke unterbrochen wird, wird der Auslesestrahl eingeschaltet und das Bild auf der Kamera ausgewertet.

Es ist auch möglich, die Kamera mit einer definierten Zeitverzögerung zum Auslesestrahl einzuschalten.

Es ist ebenso denkbar, mehrere Lichtschranken zu verwenden.

Es können auch mehrere Hologramme nacheinander ausgelesen werden. Die Hologramme sind dann auf dem Informationsträger in einer Höhe, entlang einer Linie (9) im Speichermedium (17) angeordnet.

Bei der Verwendung von mehreren Hologrammen auf einem Informationsträger, die entlang einer Linie angeordnet sind, ist es denkbar, neben den Hologrammen auch noch Markierungen in den Informationsträger und/oder das Speichermedium einzufügen, die als Trigger für die Kamera und/oder den Auslesestrahl fungieren. Auf diese Weise ist es einfach möglich, der Kamera zu signalisieren, wann ein neues Hologramm abgebildet wird.

Weiterhin ist auch die Verwendung der genannten Vorrichtung als Kartenleser für Informationsträger in Form von Plastikkarten aller Art (Bankkarten, Kreditkarten, Ausweise, etc.) vorgesehen.

Gegenstand der vorliegenden Erfindung ist ein Verfahren zur Datenübermittlung, welches umfasst (a) die Daten in Form mindestens eines Fourierhologramms auf einem flachen Informationsträger, beispielsweise einer Plastikkarte zu speichern und (b) den Informationsträger durch eine Vorrichtung umfassend eine Fourieroptik, einen Fotodetektor und eine Führungsvorrichtung, welche den Informationsträger während der Bewegung durch die Vorrichtung in Bezug zum Auslesestrahl und zum Fotodetektor ausrichtet, zu bewegen und so die gespeicherten Daten auszulesen. Bevorzugt erfolgt die Bewegung des Informationsträgers durch die Vorrichtung während des Auslesevorgangs durch manuellen Durchzug.

Ein weiterer Gegenstand der vorliegenden Erfindung ist ein System zur Datenübermittlung umfassend mindestens einen flachen Informationsträger, beispielsweise eine Plastikkarte, der Daten in Form mindestens eines Fourierhologramms gespeichert enthält, und mindestens eine Lesevorrichtung umfassend eine Fourieroptik, einen Fotodetektor und eine Führungsvorrichtung, welche den Informationsträger während der Bewegung während des Auslesevorgangs, insbesondere des manuellen Durchzugs durch die Vorrichtung in Bezug zum Auslesestrahl und zum Fotodetektor ausrichtet.

Ein solches System ist für eine Vielzahl von Anwendungen brauchbar, so beispielsweise für die Authentifizierung von Personen oder Gütern oder die Zugangskontrolle zu Gebäuden oder Räumen.

### Bezeichnungen zu den Abbildungen

- 1: Informationsträger (Plastikkarte)
- 2: Fourierhologramm
- 3: Lichtquelle mit Kollimationsoptik
- 4: Strahlteiler
- 5: Fourierlinse
- 6: Detektor (Kamera)
- 7: Kollimierter Lichtstrahl (Auslesestrahl)
- 8: Abbildung auf der Kamera
- 9: Linie, entlang derer Hologramm gespeichert werden können
- 10: Führungsschiene 1
- 11: Führungsschiene 2
- 12: Rolle
- 13: Andrückfeder
- 14: Detektor (Gabellichtschranke)
- 15: Nut
- 16: Bohrung für Auslesestrahl
- 17: Speichermedium

## Patentansprüche

1. System zur Datenübermittlung umfassend mindestens einen flachen Informationsträger, der Daten in Form von Fourierhologrammen, die entlang einer Linie angeordnet sind, gespeichert enthält, und mindestens eine Lesevorrichtung umfassend eine Lichtquelle zur Erzeugung eines Auslesestrahls, eine Fourieroptik, einen Fotodetektor, **gekennzeichnet durch** eine Führungsvorrichtung, welche die Bewegung des Informationsträgers während des manuellen Durchzugs **durch** die Lesevorrichtung in zwei Raumrichtungen einschränkt, während der Informationsträger beim. Auslesen der Fonriethologramme in die dritte Raumrichtung in Bezug zum Auslesestrahl und zum Fotodetektor manuell bewegt wird.

2. Verwendung des Systems nach Anspruch 1 zur Authentifizierung oder zur Zugangskontrolle.

3. Verfahren zur Datenübermittlung, welches umfasst (a) die Daten in Form von Fourierhologrammen entlang einer Linie auf einem flachen Informationsträger, insbesondere einer Plastikkarte zu speichern und (b) den Informationsträger durch eine Vorrichtung umfassend eine Lichtquelle zur Erzeugung eines Auslesestrahls, eine Fourieroptik, einen Fotodetektor und eine Führungsvorrichtung, welche den Informationsträger während der Bewegung durch die Vorrichtung in Bezug zum Auslesestrahl und zum Fotodetektor ausrichtet, manuell zu bewegen und dabei mehrere Fourierhologramme nacheinander auszulesen.

4. Verfahren nach Anspruch 3, **dadurch gekennzeichnet, dass** der beim Auftreffen des Auslesestrahls auf ein Fourierhologramm entstehende Auslesespot kleiner als das Fourierhologramm ist.

5. Verfahren nach Anspruch 3 oder 4, **dadurch gekennzeichnet, dass** mehrere identische Fourierhologramme zu einem größeren Hologramm zusammengesetzt sind.

6. Verfahren nach einem der Ansprüche 3 bis 5, **dadurch gekennzeichnet, dass** auf dem Informationsträger Markierungen aufgebracht sind, die als Trigger-Signal für den Auslesestrahl und/oder den Detektor dienen.

## Claims

1. System for data transmission comprising at least one flat information carrier, which contains data stored in the form of Fourier holograms which are arranged along a line, and at least one reading device comprising a light source for producing a read beam, Fourier optics, a photodetector, **characterized by** a guide device, which restricts the movement of the information carrier as it is drawn manually through the reading device in two spatial dimensions while the information carrier is moved manually in the third spatial direction in relation to the read beam and to the photodetector during reading of the Fourier holograms.

2. Use of the system according to Claim 1 for authentication or for access control.

3. Method for data transmission which comprises (a) storing the data in the form of Fourier holograms along a line on a flat information carrier, in particular a plastic card, and (b) manually moving the information carrier through a device comprising a light source for producing a read beam, Fourier optics, a photodetector and a guide device, which aligns the information carrier in relation to the read beam and to the photodetector during the movement through the device, and successively reading a plurality of Fourier holograms in this way.

4. Method according to Claim 3, **characterized in that** the spot produced when the read beam meets a Fourier hologram is smaller than the Fourier hologram.

5. Method according to Claim 3 or 4, **characterized in that** a plurality of identical Fourier holograms are combined to form a larger hologram.

6. Method according to one of Claims 3 to 5, **characterized in that** markings are applied to the information carrier which are used as a trigger signal for the read beam and/or the detector.

## Revendications

1. Système pour la communication ou le transfert de données comprenant au moins un support d'informations plat, qui renferme de manière mémorisée des données sous la forme d'hologrammes de Fourier agencés le long d'une ligne, et au moins un dispositif de lecture englobant une source de lumière pour produire un rayon de lecture, une optique de Fourier et un photo-détecteur,
**caractérisé**
**par** un dispositif de guidage, qui restreint le mouvement du support d'informations dans deux directions spatiales pendant le passage à entraînement manuel à travers le dispositif de lecture, tandis que le support d'informations, lors de la lecture des hologrammes de Fourier, est déplacé manuellement, dans la troisième direction spatiale, par rapport au rayon de lecture et au photo-détecteur.

2. Utilisation du système selon la revendication 1, pour une authentification ou pour un contrôle d'accès.

3. Procédé pour la communication ou le transfert de données, qui consiste
a) à mémoriser les données sous la forme d'hologrammes de Fourier le long d'une ligne sur un support d'informations plat, notamment sur une carte en plastique, et
b) à déplacer manuellement le support d'informations à travers un dispositif comprenant une source de lumière pour produire un rayon de lecture, une optique de Fourier, un photo-détecteur et un dispositif de guidage, qui oriente le support d'informations pendant le déplacement à travers le dispositif, par rapport au rayon de lecture et au photo-détecteur, en permettant à l'occasion de ce déplacement la lecture successive de plusieurs hologrammes de Fourier.

4. Procédé selon la revendication 3, **caractérisé en ce que** le spot de lecture engendré lors de l'impact du rayon de lecture sur un hologramme de Fourier, est plus petit que l'hologramme de Fourier.

5. Procédé selon la revendication 3 ou la revendication 4, **caractérisé en ce que** plusieurs hologrammes de Fourier identiques sont regroupés en un hologramme plus grand.

6. Procédé selon l'une des revendications 3 à 5, **caractérisé en ce que** sur le support d'informations sont placés des marques, qui servent de signal de déclenchement pour le rayon de lecture et/ou le détecteur.
